Europäisches Patentamt

European Patent Office

Office européen des brevets

(19)

(11) Veröffentlichungsnummer: **0 179 274**

**A2**

(12) **EUROPÄISCHE PATENTANMELDUNG**

(21) Anmeldenummer: **85111800.0**

(22) Anmeldetag: **18.09.85**

(51) Int. Cl.⁴: **G 03 F 3/10**
G 03 F 7/08, G 03 F 7/02

(30) Priorität: **22.10.84 US 663607**

(43) Veröffentlichungstag der Anmeldung:
**30.04.86 Patentblatt 86/18**

(84) Benannte Vertragsstaaten:
**DE FR GB IT NL SE**

(71) Anmelder: **AMERICAN HOECHST CORPORATION**
**Route 202-206 North**
**Somerville, N.J. 08876(US)**

(72) Erfinder: **Platzer, Stephan J. W.**
**106 Hamilton Street**
**New Brunswick New Jersey 08901(US)**

(72) Erfinder: **Koletar, Gabor I.**
**212 Dogwood Lane**
**Berkeley Heights New Jersey 07922(US)**

(72) Erfinder: **Shadrach, Richard L.**
**25 Alpine Court**
**Belle Mead New Jersey 08502(US)**

(74) Vertreter: **Euler, Kurt Emil, Dr. et al,**
**KALLE Niederlassung der Hoechst AG Rheingaustrasse**
**190 Postfach 3540**
**D-6200 Wiesbaden 1(DE)**

(54) Verfahren zur Herstellung eines Mehrfarbenbildes.

(57) Die Erfindung betrifft ein Verfahren zur Herstellung eines Mehrfarbenbildes, bei dem ein lichtempfindliches Material, bestehend aus einem temporären Schichtträger, einer lichtempfindlichen Schicht, die ein Bindemittel, eine positiv arbeitende Naphthochinondiazidverbindung und einen Farbstoff oder ein Pigment einer bestimmten Grundfarbe enthält, und einer Haftschicht auf der lichtempfindlichen Schicht, auf einen permanenten Schichtträger unter Druck und Erwärmen laminiert wird, die lichtempfindliche Schicht bildmäßig belichtet, der temporäre Schichtträger abgezogen und die belichtete Schicht durch Auswaschen der belichteten Bereiche entwickelt wird, wobei die lichtempfindliche Schicht als Bindemittel ein Polyvinylbutyral und bzw. oder ein Styrol-Maleinsäureanhydrid-Copolymeres und die Haftschicht ein Vinylacetat-Polymeres enthalten und die Haftschicht einen Erweichungspunkt im Bereich von 60 bis 180 °C hat, daß man die Entwicklung der belichteten lichtempfindlichen Schicht bei einer Temperatur durchführt, bei der die Haftschicht nicht klebrig ist und daß man die vorstehenden Schritte mindestens einmal mit einem lichtempfindlichen Material wiederholt, das einen Farbstoff oder ein Pigment in einer anderen Grundfarbe enthält, wobei das zweite lichtempfindliche Material auf das erste entwickelte Teilfarbenbild laminiert wird.

AMERICAN HOECHST CORPORATION
Somerville, N.J. 08876/USA

84/K104

13. September 1985
WLK-Dr.S.-gv

0179274

## VERFAHREN ZUR HERSTELLUNG EINES MEHRFARBENBILDES

Im Mehrfarbendruck wird im allgemeinen eine Farbprüfung vorgenommen, um die Korrektur der für die Belichtung von Druckplatten verwendeten Farbauszüge zu ermöglichen. Die Farbprüfung soll die beim Drucken erhaltene Farbqualität wiedergeben. Das Prüfbild muß ein getreues Abbild des gewünschten Raster- oder Strichbildes sein und soll den Tonwert der Farben weder erhöht noch herabgesetzt wiedergeben. Die visuelle Prüfung soll Fehler in der Vorlage anzeigen, die beste Farbwiedergabe, die beim Drucken in der Druckmaschine von dem Material zu erwarten ist, ermöglichen, die genaue Gradation aller Farbtöne wiedergeben und anzeigen, ob die Grautöne neutral sind, und soll die eventuelle Notwendigkeit zur Abschwächung einer der Farben angeben und/oder Hinweise zur Änderung der Filmvorlage vor der Herstellung der Druckplatten ergeben.

Farbprüfbogen für den Mehrfarbendruck sind bisher mit Hilfe eines sogenannten Andrucks angefertigt worden. Dazu müssen alle für den tatsächlichen Mehrfarbendruck notwendigen Schritte unternommen werden. Ein solches Farbprüfverfahren ist kostspielig und zeitaufwendig, und man hat deshalb alternative Farbprüfverfahren entwickelt, die dem Andruck in der Qualität gleichkommen sollen. Zwei photographische Farbprüfverfahren sind bekannt, nämlich das sogenannte Overlay-Verfahren (Ubereinanderlegen) und das sogenannte Surprint-Verfahren (Ubereinanderkopieren).

AMERICAN HOECHST CORPORATION
Somerville, N.J. 08876/USA

- 2 -

Beim Farbprüfen nach dem Overlay-Verfahren wird auf jeweils einem transparenten Kunststoffträger von jeder Farbauszugsfolie für sich ein Teilbild der entsprechenden Farbe hergestellt. Zur Herstellung eines Farbprüfsatzes werden dann mehrere solcher mit Farbbildern versehenen transparenten Kunststoffträger übereinander auf ein weißes Blatt gelegt. Das Overlay-Vefahren hat den Nachteil, daß die übereinanderliegenden Kunststoffträger dazu neigen, das Mehrfarbenbild dunkler zu machen, so daß der Eindruck, den man von dem so angefertigten Farbprüfsatz erhält, sich sehr stark von Drucken unterscheidet, die man mit einem konventionellen Andruck erzielt. Der Hauptvorteil dieses Verfahrens besteht darin, daß es schnell ist und durch passergenaues Kombinieren von jeweils zwei oder mehreren Teilfarbenbildern zur Prüfung von Korrekturen dienen kann.

Beim Farbprüfen nach dem Surprint-Verfahren wird ein Farbprüfbild angefertigt, indem nacheinander Teilbilder in verschiedenen Farben von verschiedenen Farbauszugsfolien auf einem einzigen Empfangsblatt hergestellt werden. Dazu wird ein undurchsichtiger Träger verwendet, auf den nacheinander Toner, lichtempfindliche Lösungen oder Beschichtungen aus lichtempfindlichen Materialien in den entsprechenden Farben aufgebracht werden, wie es zum Beispiel in US-A 3,671,236 beschrieben ist. Das Surprint-Verfahren hat den Vorteil, daß die Farbsättigung nicht durch übereinanderliegende Kunststoffträger beeinflußt wird. Dieses Verfahren kommt dem tatsächlichen Druck näher und vermeidet die dem Overlay-Verfahren eigene Farbverfälschung.

AMERICAN HOECHST CORPORATION
Somerville, N.J. 08876/USA

- 3 -

Aus den US-A 3,060,023, 3,060,024, 3,060,025, 3,481,736 und 3,607,264 sind verschiedene Verfahren zur Herstellung von Kopien eines Bildes durch Photopolymerisation und thermische Übertragung bekannt. Bei diesem Verfahren wird eine auf einen geeigneten Träger aufgebrachte photopolymerisierbare Schicht unter einer Filmvorlage bildmäßig belichtet. Die Oberfläche der belichteten Schicht wird dann auf die Oberfläche eines Bildempfangsblattes aufgelegt und angepreßt, und mindestens eines der beiden wird auf eine Temperatur erwärmt, die höher ist als die Übertragungstemperatur der unbelichteten Schichtbereiche. Dann werden die beiden Oberflächen voneinander getrennt, wobei die thermisch übertragbaren unbelichteten Bildstellen auf das Bildempfangsblatt übergehen. Wenn es nicht vorgefärbt ist, kann das klebrige unbelichtete Bild nun mit einem gewünschten Farbtoner selektiv eingefärbt werden.

US-A 3,574,049 beschreibt ein Verfahren zur Übertragung eines Bildes auf einen endgültigen Träger. Bei diesem Verfahren werden (a) ein Bild auf einen temporären Träger aufgedruckt, (b) temporärer Träger und endgültiger Träger aufeinandergelegt, (c) der hergestellte Verbund mit Wärme und/oder Druck beaufschlagt und (d) der temporäre Träger von dem endgültigen Träger, auf dem das gedruckte Bild zurückbleibt, abgetrennt. Das Haftvermögen des Bildes an dem temporären Träger ist geringer als sein Haftvermögen an dem endgültigen Träger.

AMERICAN HOECHST CORPORATION
Somerville, N.J. 08876/USA

- 4 -

In der US-A 3,721,557 wird ein Verfahren zur Übertragung von Farbbildern beschrieben, bei dem zwischen der lichtempfindlichen Schicht und dem Träger eine Trennschicht aufgebracht ist. Nachdem die lichtempfindliche Schicht mit aktinischer Strahlung belichtet und anschließend entwickelt worden ist, können die löslichen Teile der Schicht selektiv entfernt werden, und es entsteht ein sichtbares Bild. Der Träger mit dem Bild wird gegen ein geeignetes klebstoffbeschichtetes Empfangsmaterial gepreßt und dann die Bildübertragung durch Abziehen des Trägers vorgenommen. Für jede weitere Bildübertragung wird eine frische Klebstoffschicht auf das Empfangsmaterial aufgetragen.

Die US-A 4,260,673 und 4,093,464 beschreiben positiv arbeitende, aus einem Stück bestehende Farbprüfsysteme auf der Basis von Orthochinondiaziden. Gemäß US-A 4,093,464 wird ein Farbbild nach dem Belichten und Entwickeln auf ein Empfangsblatt übertragen, wogegen in der US-A 4,260,673 eine vollflächige Farbschicht vor dem Belichten und Entwickeln auf ein Empfangsblatt übertragen wird.

In der EP-A 0 115 899 ist ein lichtempfindliches Material für die Herstellung von Farbprüffolien beschrieben, das auf einem Schichtträger eine positiv arbeitende lichtempfindliche Schicht mit einem Farbstoff und eine wärmeaktivierbare Klebstoffschicht trägt. Die Schichten werden auf ein Bildempfangsmaterial laminiert, belichtet und entwickelt. Daher werden jeweils nur einzelne Teilfarbbilder hergestellt und geprüft.

AMERICAN HOECHST CORPORATION
Somerville, N.J. 08876/USA

- 5 -

Aufgabe der Erfindung war es, ein Verfahren zur Herstellung eines Mehrfarbenbildes nach der Surprint-Technik anzugeben, bei dem Positiv-Teilfarbenbilder auf ein gemeinsames Empfangsblatt übertragen oder auf diesem erzeugt werden, ohne daß ein gesondertes Aufbringen von Zwischenschichten erforderlich ist.

Gegenstand der Erfindung ist ein Verfahren zur Herstellung eines Mehrfarbenbildes, bei dem ein lichtempfindliches Material, bestehend aus einem temporären Schichtträger, einer lichtempfindlichen Schicht, die ein Bindemittel, eine positiv arbeitende Naphthochinondiazidverbindung und einen Farbstoff oder ein Pigment einer bestimmten Grundfarbe enthält, und einer Haftschicht auf der lichtempfindlichen Schicht, auf einen permanenten Schichtträger unter Druck und Erwärmen laminiert wird, wobei die Haftung der lichtempfindlichen Schicht an dem temporären Schichtträger geringer ist als die Haftung der Haftschicht auf der lichtempfindlichen Schicht und an dem temporären Schichtträger, und die lichtempfindliche Schicht bildmäßig belichtet, der temporäre Schichtträger abgezogen und die belichtete Schicht durch Auswaschen der belichteten Bereiche entwickelt wird.

Das erfindungsgemäße Verfahren ist dadurch gekennzeichnet, daß die lichtempfindliche Schicht als Bindemittel ein Polyvinylbutyral und bzw. oder ein Styrol-Maleinsäureanhydrid-Copolymeres und die Haftschicht ein Vinylacetat-Polymeres enthalten und die Haftschicht einen Erweichungspunkt im Bereich von 60 bis 180 °C hat, daß man entweder

AMERICAN HOECHST CORPORATION
Somerville, N.J. 08876/USA

- 6 -

a) nach dem Laminieren zuerst den temporären Schichtträger abzieht und danach die lichtempfindliche Schicht bildmäßig belichtet oder

b) nach dem Laminieren zuerst die lichtempfindliche Schicht belichtet und danach den temporären Schichtträger abzieht oder

c) zuerst die lichtempfindliche Schicht belichtet, dann das belichtete lichtempfindliche Material auf den permanenten Schichtträger laminiert und schließlich den temporären Schichtträger abzieht,

daß man die Entwicklung der belichteten lichtempfindlichen Schicht bei einer Temperatur durchführt, bei der die Haftschicht nicht klebrig ist und daß man die vorstehenden Schritte mindestens einmal mit einem lichtempfindlichen Material wiederholt, das einen Farbstoff oder ein Pigment in einer anderen Grundfarbe enthält, wobei das zweite lichtempfindliche Material auf das erste entwickelte Teilfarbenbild laminiert wird.

Zur Durchführung des erfindungsgemäßen Verfahrens wird ein lichtempfindliches Material eingesetzt, das generell aus einem temporären Träger mit einer wenig haftenden Oberfläche, einer farbigen lichtempfindlichen Schicht auf der Oberfläche und einer Haft- bzw. Klebeschicht auf der lichtempfindlichen Schicht besteht. Gegebenenfalls können auch noch weitere Schichten verwendet werden, die Lichthof-Schutzmittel, Haftvermittler oder Trennmittel enthalten.

AMERICAN HOECHST CORPORATION
Somerville, N.J. 08876/USA

- 7 -

In bevorzugter Ausführung besteht der temporäre Träger aus einer maßbeständigen und chemisch stabilen Polyesterfolie, die sich in Größe, Form und chemischen Eigenschaften durch Erwärmen, Beschichten oder die anderen notwendigen Behandlungen nicht wesentlich verändert. Ein bevorzugtes Material ist eine Folie aus Polyethylenterephthalat, die normalerweise eine Dicke von etwa 25,0 bis 250 µm, vorzugsweise etwa 50 bis 125 µm, und insbesondere etwa 50 bis 75 µm aufweist. Die Oberfläche des temporären Trägers kann glatt sein, oder sie kann nach verschiedenen bekannten Verfahren mit einer rauhen Struktur versehen werden. Der temporäre Schichtträger kann vorteilhaft ein transparenter Polyesterfilm sein.

Folien mit rauher Oberfläche sind im Handel erhältlich. Diese Materialien haben die außergewöhnliche Eigenschaft, daß sie dem endgültigen Bild ohne zusätzliche Arbeitsgänge die gewünschte Mattigkeit verleihen. Der Glanz des endgültigen Bildes kann durch die richtige Wahl der Oberflächenstruktur des temporären Trägers gesteuert werden. Vorteilhaft hat der temporäre Schichtträger eine mattierte Oberfläche.

Eine ähnliche Mattierung des endgültigen Bildes kann durch Prägen der glänzenden Bildoberfläche mit Hilfe eines rauhen Materials erreicht werden. Dazu werden das endgültige Bild und das rauhe Material unter Druck und Erwärmen aufeinanderlaminiert und wieder getrennt. Es kann auch eine rauhe Prägewalze verwendet werden. Die-

AMERICAN HOECHST CORPORATION
Somerville, N.J. 08876/USA

- 8 -

ses Verfahren hat den Vorteil, daß die Oberflächenbeschaffenheit des fertigen Prüfsatzes variiert werden kann. Außerdem kann das Mattierungsmaterial mehrmals verwendet werden.

In einem dritten Verfahren zur Herstellung einer Mattierung wird eine durch Wärme übertragbare Klebeschicht, zum Beispiel Butvar$^{(R)}$ 90 (Polyvinylbutyral von Monsanto) auf eine Folie mit rauher Oberfläche als temporärer Träger aufgebracht. Die Folie mit rauher Oberfläche wird mit der Seite der Klebeschicht unter Druck und Erwärmen auf das endgültige Bild laminiert und anschließend wieder abgezogen. Die rauhe Oberfläche der Folie bewirkt eine Mattierung des endgültigen Bildes. Das Verfahren hat den Vorteil, daß alle Schichten matt erscheinen und daß die zusätzliche Schicht das Bild schützt. Verschiedene Verfahren zur Herstellung einer matten Oberfläche sind weiterhin in den US-A 4,294,909 und 4,376,159 vorgeschlagen.

Der temporäre Träger muß zumindest eine trennfähige Oberfläche aufweisen, d.h. er muß fähig sein, die lichtempfindliche Schicht so zu halten, daß sie wieder von ihm getrennt werden kann. Zu diesem Zweck kann entweder die Trägeroberfläche von ihrer Natur her trennfähig sein, sie kann durch eine geeignete Behandlung trennfähig gemacht werden, oder sie kann mit einer Trennschicht versehen werden. Als eine derartige Trennschicht kann eine Schicht auf Basis von Polyvinylalkohol dienen.

Im allgemeinen enthält die lichtempfindliche Schicht neben den genannten Substanzen, wie Photosensibilisator, Farbmittel und Bindemittel, gegebenenfalls weitere Bestandteile, wie z.B. Weichmacher, saure Stabilisatoren, Tenside, Antistatika, UV-Absorber und Lösemittelreste.

Als Photosensibilisator wird vorzugsweise ein lichtempfindliches Naphthochinondiazid verwendet. Der am meisten bevorzugte Photosensibilisator ist der Ester aus Bis-(3-benzoyl-4,5,6-trihydroxyphenyl)-methan und 2-Diazo-1-naphthol-5-sulfonsäure, wie in US-A 4,407,426 beschrieben. Weitere geeignete Photosensibilisatoren sind in den US-A 4,266,001, 3,106,365, 3,148,983 und 3,201,239 genannt. Das erfindungsgemäß einsetzbare Naphthochinondiazid ist vorzugsweise in organischen Lösemitteln löslich.

Als Bindemittel geeignete Harze sind zum Beispiel Polyvinylbutyrale und Halbester aus Styrol-Maleinsäureanhydrid-Copolymerisaten oder deren Mischungen. Ein wichtiges Kriterium bei der Wahl des Bindemittels ist seine gute Filmbildungseigenschaft.

Zu den erfindungsgemäß geeigneten Farbmitteln zählen verschiedene Farbstoff- und Pigmentklassen. In der am meisten bevorzugten Ausführung werden Pigmente mit einer durchschnittlichen Teilchengröße von höchstens etwa 1 μm eingesetzt.

AMERICAN HOECHST CORPORATION
Somerville, N.J. 08876/USA

- 10 -

Als Weichmacher können Verbindungen vom Phthalat- oder
Phosphattyp zugesetzt werden. Bevorzugte Weichmacher
sind Dibutylphthalat oder Dimethylphthalat.

Die einzelnen Komponenten könnnen in verträglichen Lösemitteln, wie zum Beispiel Propylenglykolmonomethylether, Ethylenglykolmonomethylether, $\gamma$-Butyrolacton
und Methylethylketon, gelöst, auf die Trennfläche des
temporären Trägers aufgetragen und getrocknet werden.
In bevorzugter Ausführung hat die lichtempfindliche
Schicht ein Schichtgewicht zwischen etwa 0,1 und 5,0
$g/m^2$. Insbesondere liegt das Schichtgewicht zwischen
0,5 und 2,0 $g^2$.

In der bevorzugten Ausführungsform sind die Komponenten
in folgenden Anteilen in der lichtempfindlichen Schicht
enthalten: der Photosensibilisator von etwa 15 bis 60,
insbesondere von etwa 20 bis 50 Gewichtsprozent, das
Farbmittel von etwa 10 bis 40, insbesondere von etwa 13
bis 34 Gewichtsprozent, das Bindemittel von etwa 20 bis
75, insbesondere von etwa 30 bis 70 Gewichtsprozent,
der gegebenenfalls verwendete Weichmacher von bis zu
etwa 20, vorzugsweise bis zu etwa 15 und insbesondere
von etwa 12 bis 15 Gewichtsprozent.

Typische Zusammensetzungen für die lichtempfindlichen
Beschichtungslösungen sind die folgenden:

|                                                      | Cyan  | Gelb  | Magenta | Schwarz |
|------------------------------------------------------|-------|-------|---------|---------|
| Diacetonalkohol                                      | -     | 11,7  | -       | -       |
| Methylethylketon                                     | 35,52 | 34,45 | 24,23   | 38,62   |
| γ-Butyrolacton                                       | 22,60 | 11,15 | 24,04   | 5,74    |
| Propylenglykolmono-methylether (Dowanol PM)          | 34,76 | 35,21 | 44,94   | 48,34   |
| Styrol/Maleinsäure-anhydrid-Mischpoly-merisat (Scripset 540) | 1,60  | 2,01  | 2,15    | 2,39    |
| SMA 2625                                             | 1,74  | 1,17  | -       | 0,60    |
| Polyvinylbutyral (Butvar B-90)                      | 0,58  | 0,59  | 0,67    | 0,30    |
| o.g. Photosensibili-sator aus US-A 4,407,426        | 2,09  | 2,58  | 2,81    | 2,72    |
| Phthalocyaninblau                                    | 1,11  | -     | -       | -       |
| gelbes Pigment                                       | -     | 1,08  | -       | -       |
| Magenta-Pigment                                      | -     | -     | 1,15    | -       |
| schwarzes Pigment                                    | -     | -     | -       | 1,29    |
| optische Dichte                                      | 1,2   | 1,0   | 1,4     | 1,6     |

Die Scripset-Harze werden von Monsanto, die SMA-Harze von Arco hergestellt. Dowanol PM ist von der Firma Dow.

Die Klebeschicht besteht aus Polyvinylacetat. Sie kann gegebenenfalls weitere gewünschte Komponenten, wie zum Beispiel UV-Absorber, Antistatika und Weichmacher enthalten. Beispiele für geeignete Polyvinylacetate sind

AMERICAN HOECHST CORPORATION
Somerville, N.J. 08876/USA

- 12 -

Mowilith DM-6, 20, DM-22, 25, 30 und Mischungen daraus (Hersteller Hoechst AG). Die Polyvinylacetate werden gewöhnlich in Wasser dispergiert oder in Methylisobutylketon oder n-Butylacetat oder anderen Lösemittelgemischen gelöst und auf die lichtempfindliche Schicht aufgebracht. Dabei darf keine Vermischung der beiden Schichten eintreten. Die Schicht wird dann getrocknet, so daß sich ein Schichtgewicht von etwa 5 bis 30 $g/m^2$, bevorzugt von etwa 7 bis 20 $g/m^2$, ergibt. In der Schicht können gegebenenfalls UV-Absorber, wie zum Beispiel Uvinul D-50 (Hersteller G.A.F), Weichmacher, wie zum Beispiel Resoflex R-296 (Hersteller Cambridge Industries), sowie Antistatika, zum Beispiel Gafac und Gafstat (Hersteller G.A.F) und weitere Harze, zum Beispiel Nitrocellulose R 1/2 (Hersteller Hercules), enthalten sein. Während der Lagerung oder Entwicklung des lichtempfindlichen Elements soll sich die Klebeschicht nicht klebrig anfühlen. Die Schicht soll einen Erweichungspunkt im Bereich von etwa 60 bis 180 °C, vorzugsweise von 60 bis 120 °C, insbesondere von 60 bis 100 °C, haben. In bevorzugter Ausführung ist das Polyvinylacetat in einem Anteil von mehr als 50 Gewichtsprozent in der Klebeschicht enthalten. Der Weichmacher kann in einem Anteil von bis zu etwa 30 Gewichtsprozent, der UV-Absorber bis zu etwa 20 Gewichtsprozent und andere Harze bis zu etwa 50 Gewichtsprozent in der Schicht anwesend sein.

Die Klebeschicht kann zum Beispiel die folgenden Zusammensetzungen haben:

AMERICAN HOECHST CORPORATION
Somerville, N.J. 08876/USA

- 13 -

| I. | Wasser | 50,00 |
| | Mowilith DM-22 | 50,00 |
| | | |
| II. | n-Butylacetat | 78,00 |
| | Resoflex R-296 | 1,00 |
| | Mowilith 25 | 21,00 |
| | | |
| III. | Isopropylacetat | 70,00 |
| | Mowilith 30 | 30,00 |
| | | |
| IV. | Isopropylacetat | 49,00 |
| | Cyclohexan | 21,00 |
| | Mowilith 25 | 30,00 |

Bei der praktischen Anwendung wird das erfindungsgemäße lichtempfindliche Aufzeichnungsmaterial mit der Klebeschicht auf ein Empfangsblatt laminiert. Das Empfangsblatt soll beständig gegen irgendwelche Beeinträchtigungen durch den gewählten Entwickler sein. Bei Verwendung von wäßrigen Entwicklern soll es zum Beispiel wasserfest sein. Für diesen Zweck sind Kunststoff-Folien oder kunststoffbeschichtete Papiere geeignet.

Es können aber auch andere weiße und nicht weiße Empfangsmaterialien verwendet werden. Die Oberfläche des Empfangsblattes hat vorzugsweise eine rauhe Struktur und/oder ist haftvermittelnd behandelt worden, und sie muß unempfindlich gegen die Laminier- und Entwicklungsvorgänge sein.

AMERICAN HOECHST CORPORATION
Somerville, N.J. 08876/USA

- 14 -

Das Laminieren kann so durchgeführt werden, daß das Empfangsblatt mit der Klebeseite des farbigen lichtempfindlichen Aufzeichnungsmaterials in Kontakt gebracht wird und dann beide Materialien unter entsprechendem Druck zusammen durch den Walzenspalt eines beheizten Laminierwalzenpaares geführt werden. Geeignete Laminiertemperaturen liegen im allgemeinen bei etwa 60 bis 90 °C, vorzugsweise bei 75 bis 85 °C. Nach dem Laminieren wird der temporäre Träger abgezogen, was normalerweise einfach von Hand geschieht. Die Klebeschicht und die lichtempfindliche Schicht bleiben dabei auf dem Empfangsblatt zurück.

Die lichtempfindliche Schicht wird entweder vor oder nach dem Laminieren in bekannter Weise bildmäßig belichtet. Es kann zum Beispiel mit einer UV-Lichtquelle durch eine Photomaske im Vakuumkopierrahmen belichtet werden. Die Belichtung kann mit aktinischem Licht durch eine übliche Positivvorlage efolgen. Wenn die Emulsionsschichten bei der Belichtung miteinander in Kontakt sind, wird vorzugsweise nach dem Laminieren und Abziehen des temporären Trägers belichtet. Quecksilberdampflampen werden gegenüber Metallhalogenidlampen bevorzugt. Es können auch Filter verwendet werden, um die Lichtstreuung im Material zu reduzieren.

Nach dem Laminieren, Abziehen des temporären Trägers und Belichten wird die lichtempfindliche Schicht entwickelt, indem die belichteten Bereiche in einem geeigneten Entwickler abgelöst werden. Anschließend wird getrocknet. Die Klebeschicht wird beim Entwickeln nicht entfernt. Geeignete Entwickler sind zum Beispiel:

| I. | Wasser | 95,0 |
| | Natriumdecylsulfat | 3,0 |
| | Dinatriumphosphat | 1,5 |
| | Natriummetasilikat | 0,5 |

| II. | Wasser | 89,264 |
| | Mononatriumphosphat | 0,269 |
| | Trinatriumphosphat | 2,230 |
| | Natriumtetradecylsulfat | 8,237 |

Es kann jede Entwicklerlösung verwendet werden, die die belichteten Bereiche der lichtempfindlichen Schicht einwandfrei entfernt und die Bildstellen zurückläßt.

Der Vorgang kann dann wiederholt werden, wobei ein weiteres lichtempfindliches Aufzeichnungsmaterial in einer anderen Farbe über das zuvor hergestellte Bild auf dasselbe Empfangsblatt laminiert wird. Um die komplette Farbwiedergabe eines gewünschten Bildes zu erhalten, werden normalerweise vier farbige Schichten verwendet. Diese Farbschichten umfassen Cyan, Magenta, Gelb und Schwarz.

Die Erfindung wird durch das folgende Beispiel näher erläutert.

AMERICAN HOECHST CORPORATION
Somerville, N.J. 08876/USA

- 16 -

Beispiel

Es werden vier lichtempfindliche Lösungen in den Farben Cyan, Gelb, Magenta und Schwarz nach den oben angegebenen Rezepturen für die lichtempfindlichen Lösungen hergestellt. Das Pigment wird der Lösung jeweils in Form einer Dispersion aus Methylethylketon, Styrol/Maleinsäureanhydrid-Copolymerisat (Halbester) (Scripset 540) und dem entsprechenden Pigment zugegeben. Die Lösungen werden einzeln auf etwa 75 µm dicke Polyesterfolien als temporäre Träger so aufgebracht und getrocknet, daß sich die erforderliche optische Dichte ergibt. Die Schichtdicken betragen ungefähr 1,2 g/m$^2$ für Cyan, 1,4 g/m$^2$ für Gelb, 2,0 g/m$^2$ für Magenta und 1,0 g/m$^2$ für Schwarz. Die Kleberlösung, insbesondere nach der oben angegebenen Kleberrezeptur III, wird auf die lichtempfindlichen Schichten aufgebracht und zu einer Oberflächenschichtdicke von 8 g/m$^2$ getrocknet. Das gelbe Material wird dann bei 80 °C mit der Kleberseite beliebig auf eine der beiden Seiten eines etwa 175 µm dicken Polyesterempfangsblattes laminiert. Der temporäre Träger wird nach dem Laminieren abgezogen, wobei die Klebeschicht und die lichtempfindliche Schicht auf dem Empfangsblatt verbleiben. Die gelbe lichtempfindliche Schicht wird dann unter einer Montage für die gelbe Farbe mit aktinischer Strahlung belichtet. Das Empfangsblatt mit der belichteten gelben Schicht wird bei 27 °C 15 Sekunden lang in den oben genannten Entwickler II getaucht und dabei auf der lichtempfindlichen Seite leicht überrieben. Die belichteten gelben Bereiche wer-

0179274

AMERICAN HOECHST CORPORATION
Somerville, N.J. 08876/USA

- 17 -

den beim Entwickeln abgewaschen, die nicht belichteten Bereiche bleiben zurück. Die Klebeschicht wird durch den Entwickler nicht angegriffen. Nach dieser Behandlung wird das bebilderte Material abgespült und getrocknet. Das magentafarbene lichtempfindliche Aufzeichnungsmaterial wird dann, wie oben beschrieben, auf die bebilderte gelbe Seite des Empfangsblattes laminiert und der temporäre Träger abgezogen. Anschließend wird die magentafarbene Schicht durch die entsprechende Montage belichtet und wie die gelbe Schicht verarbeitet. Auf Magenta folgen in gleicher Weise Cyan und dann Schwarz, so daß man schließlich ein Vierfarbenbild erhält, das eine genaue Wiedergabe des Originals ist, von dem man Farbauszüge herstellen kann.

- - - - - - -

AMERICAN HOECHST CORPORATION
Somerville, N.J. 08876/USA

84/K104                    - 18 -              13. September 1985
                                               WLK-Dr.S.-gv


PATENTANSPRÜCHE


1. Verfahren zur Herstellung eines Mehrfarbenbildes, bei dem ein lichtempfindliches Material, bestehend aus einem temporären Schichtträger, einer lichtempfindlichen Schicht, die ein Bindemittel, eine positiv arbeitende Naphthochinondiazidverbindung und einen Farbstoff oder ein Pigment einer bestimmten Grundfarbe enthält, und einer Haftschicht auf der lichtempfindlichen Schicht, auf einen permanenten Schichtträger unter Druck und Erwärmen laminiert wird, wobei die Haftung der lichtempfindlichen Schicht an dem temporären Schichtträger geringer ist als die Haftung der Haftschicht auf der lichtempfindlichen Schicht und an dem temporären Schichtträger, und die lichtempfindliche Schicht bildmäßig belichtet, der temporäre Schichtträger abgezogen und die belichtete Schicht durch Auswaschen der belichteten Bereiche entwickelt wird, dadurch gekennzeichnet, daß die lichtempfindliche Schicht als Bindemittel ein Polyvinylbutyral und bzw. oder ein Styrol-Maleinsäureanhydrid-Copolymeres und die Haftschicht ein Vinylacetat-Polymeres enthalten und die Haftschicht einen Erweichungspunkt im Bereich von 60 bis 180 °C hat, daß man entweder

a) nach dem Laminieren zuerst den temporären Schichtträger abzieht und danach die lichtempfindliche Schicht bildmäßig belichtet oder

AMERICAN HOECHST CORPORATION
Somerville, N.J. 08876/USA

- 19 -

b) nach dem Laminieren zuerst die lichtempfindliche Schicht belichtet und danach den temporären Schichtträger abzieht oder

c) zuerst die lichtempfindliche Schicht belichtet, dann das belichtete lichtempfindliche Material auf den permanenten Schichtträger laminiert und schließlich den temporären Schichtträger abzieht,

daß man die Entwicklung der belichteten lichtempfindlichen Schicht bei einer Temperatur durchführt, bei der die Haftschicht nicht klebrig ist und daß man die vorstehenden Schritte mindestens einmal mit einem lichtempfindlichen Material wiederholt, das einen Farbstoff oder ein Pigment in einer anderen Grundfarbe enthält, wobei das zweite lichtempfindliche Material auf das erste entwickelte Teilfarbenbild laminiert wird.

2. Verfahren nach Anspruch 1, dadurch gekennzeichnet, daß der temporäre Schichtträger ein transparenter Polyesterfilm ist.

3. Verfahren nach Anspruch 1, dadurch gekennzeichnet, daß der temporäre Schichtträger eine mattierte Oberfläche hat.

4. Verfahren nach Anspruch 1, dadurch gekennzeichnet, daß das Gewicht der lichtempfindlichen Schicht 0,1 bis 5 g/m$^2$ beträgt.

AMERICAN HOECHST CORPORATION
Somerville, N.J. 08876/USA

- 20 -

5. Verfahren nach Anspruch 1, dadurch gekennzeichnet, daß die lichtempfindliche Schicht 10 bis 40 Gewichtsprozent Farbstoff oder Pigment enthält.

6. Verfahren nach Anspruch 1, dadurch gekennzeichnet, daß die lichtempfindliche Schicht 15 bis 60 Gewichtsprozent Photosensibilisator enthält.

7. Verfahren nach Anspruch 1, dadurch gekennzeichnet, daß die lichtempfindliche Schicht 20 bis 75 Gewichtsprozent Bindemittel enthält.

-.-.-